# EUROPÄISCHE PATENTSCHRIFT

(11) **EP 3 011 072 B1**
(45) Veröffentlichungstag und Bekanntmachung des Hinweises auf die Patenterteilung: **31.01.2018**
(21) Anmeldenummer: 14728952.4
(22) Anmeldetag: 06.06.2014
(51) Int. Cl.: C23C 18/12, H01L 21/02

(54) **VERFAHREN ZUR HERSTELLUNG STRUKTURIERTER BESCHICHTUNGEN AUS SILIZIUM UND/ODER GERMANIUM**
PROCESS FOR PREPARING STRUCTURED COATINGS OF SILICIUM AND/OR GERMANIUM
PROCÉDÉ DE PRÉPARATION DE REVÊTEMENTS STRUCTURÉS EN SILICIUM ET/OU GERMANIUM

(30) Priorität: 18.06.2013 DE 102013010099
(43) Veröffentlichungstag der Anmeldung: 27.04.2016
(73) Patentinhaber: Evonik Degussa GmbH, 45128 Essen (DE)
(72) Erfinder: MADER, Christoph, 48153 Münster (DE); WÖBKENBERG, Paul Henrich, 27243 Hölingen (DE); ERZ, Joachim, 79739 Schwörstadt (DE); TRAUT, Stephan, 79541 Lörrach Brombach (DE); PATZ, Matthias, 46240 Bottrop (DE); CÖLLE, Michael, 90596 Schwanstetten (DE); WIEBER, Stephan, 76137 Karlsruhe (DE); STENNER, Patrik, 63452 Hanau (DE); KLATT, Janette, 45721 Haltern am See (DE); WUNNICKE, Odo, 48161 Münster (DE)
(86) Internationale Anmeldenummer: PCT/EP2014/061789
(87) Internationale Veröffentlichungsnummer: WO 2014/202405

(56) Entgegenhaltungen:
- EP-A1- 1 087 428
- WO-A1-2009/086105
- US-A1- 2008 308 143

## Beschreibung

Die vorliegende Erfindung betrifft ein Verfahren zur Herstellung strukturierter Silicium- und/oder Germanium-haltiger Beschichtungen, die nach dem Verfahren erhältlichen Schichten und ihre Verwendung.

Für verschiedene Anwendungen werden strukturierte leitende, halbleitende oder isolierende Beschichtungen benötigt, z.B. für die Verwendung in Dioden, für Emitter- und Basisbereiche in Back-Contact-Solarzellen oder als Barrieren auf Stahl oder Glas.

Im Stand der Technik sind bereits Verfahren zur Herstellung strukturierter Beschichtungen bekannt. So gibt es bereits verschiedene Techniken zur Herstellung strukturierter Oberflächen, die auf Photolithographietechniken, Naß-Ätzverfahren und/oder Laser-Ablation beruhen (P. Engelhart et al., Prog. Photovolt: Res. Appl. 15 (3), 237 - 243, Mai 2007); J. Haschke et al., Energy Procedia 27(2012) 116 - 121; N.-P. Harder, Phys. Stat. Sol. (RRL) 2, No. 4, 148 - 150 (2008); M. Z. Rahman, Optics and Photonics Journal, 2012, 2, 129 - 134). Diesen Verfahren ist jedoch gemein, dass sie technisch sehr aufwändig sind und sich damit nur schlecht feine Strukturen herstellen lassen.

Insbesondere für Halbleiteranwendungen sind strukturierte Silicium- und/oder Germanium-haltige Beschichtungen, insbesondere sehr feine Schichtstrukturen, jedoch von großem Interesse.

Strukturierte Silicium- und/oder Germanium-haltige Beschichtungen können auch über Druckverfahren hergestellt werden. So offenbart zum Beispiel WO 2009/086105 A1 ein Verfahren, bei dem gezielt ein ausgewählter Bereich eines Substrates mit einem flüssigen Silan beschichtet, insbesondere bedruckt, und nachfolgend in ein polymerisiertes Material konvertiert wird. Auch EP 1 087 428 A1 offenbart ein Verfahren zur Herstellung eines Silicium-Filmes, bei dem eine Drucktinte enthaltend eine Siliciumverbindung über einen Inkjet-Prozeß strukturiert auf ein Substrat aufgebracht wird. Auch WO 2008/137811 A2 offenbart ein Verfahren zur Herstellung eines mit einem strukturierten Material beschichteten Substrates, bei dem eine Prekursorhaltige Drucktinte über ein Druckverfahren in Form einer Linie auf das Substrat aufgebracht und konvertiert wird. Auch hiermit lassen sich jedoch nicht hinreichend feine Strukturen erzielen.

Eine andere Alternative zur Herstellung strukturierter Silicium- und/oder Germanium-haltiger Beschichtungen wird in US 8,124,040 B1 offenbart. Hier wird ein Verfahren zur Herstellung Silicium- oder Germanium-haltiger Filme beschrieben, bei dem Beschichtungszusammensetzungen umfassend cyclische Silicium- und/oder Germanium-haltige Prekursoren auf ein Substrat aufgebracht werden. Nachfolgend wird ein strukturierter Film über selektive Bestrahlung hergestellt (insbesondere durch Bestrahlen mit einer Maske) und der in den nicht bestrahlten Bereichen befindliche Film wird mit einem geeigneten Lösemittel abgewaschen. Auch über dieses Verfahren lassen sich jedoch nicht hinreichend feine Strukturen herstellen. Weiterhin kann der Waschschritt die elektrischen Eigenschaften der verbleibenden Schicht negativ beeinträchtigen. Weiterhin sind - vermutlich aufgrund des Waschschrittes - die Begrenzungen der strukturierten Schicht nicht ausreichend scharf, was zu Nachteilen in elektronischen Bauteilen führt.

Es ist somit die Aufgabe der vorliegenden Erfindung, ein Verfahren zur Herstellung strukturierter Silicium- und/oder Germanium-haltiger Beschichtungen bereitzustellen, das die Nachteile des Standes der Technik vermeidet und mit dem insbesondere besonders feine Strukturen mit scharfen Begrenzungen hergestellt werden können.

Die vorliegende Aufgabe wird gelöst durch das erfindungsgemäße Flüssigphasenverfahren zur Herstellung strukturierter Silicium- und/oder Germanium-haltiger Beschichtungen, bei dem mindestens eine Beschichtungszusammensetzung auf ein Substrat aufgebracht, die resultierende Beschichtung auf dem Substrat partiell aktiviert und nicht aktivierte Beschichtung auf dem Substrat oxidiert wird.

Unter einem Flüssigphasen-Verfahren ist vorliegend ein Verfahren zu verstehen, bei dem flüssige Edukte (ggf. fungierend als Lösemittel für weitere Additive und/oder Dotierstoffe) oder flüssige Lösungen enthaltend die (selbst flüssigen oder festen) Edukte (und ggf. weitere Additive und/oder Dotierstoffe; letztere insbesondere in Form von Elementverbindungen der III. und V. Hauptgruppe) auf das zu beschichtende Substrat aufgebracht und nachfolgend thermisch, mit elektromagnetischer Strahlung und/oder durch Elektronenstrahl- oder Ionenbeschuss in eine im Wesentlichen elementare, amorphe, monokristalline und/oder polykristalline Silicium- oder Germanium-haltige Beschichtung, bevorzugt in eine elementare, amorphe, monokristalline und/oder polykristalline Silicium- oder Germanium-haltige Beschichtung umgewandelt werden. Unter einer "Aktivierung" im Sinne der vorliegenden Erfindung ist somit eine "thermische Konvertierung und/oder eine Konvertierung mit elektromagnetischer Strahlung und/oder durch Elektronenstrahl- oder Ionenbeschuss" zu verstehen.

Die nach dem erfindungsgemäßen Verfahren herstellbaren strukturierten Silicium- und/oder Germanium-haltigen Beschichtungen können elementares Silicium, elementares Germanium oder ein Gemisch von elementarem Silicium und Germanium enthalten oder aus ihnen bestehen. Die mit dem erfindungsgemäßen Verfahren herstellbaren strukturierten Beschichtungen können somit aus reinem Silicium, reinem Germanium oder einem reinen Gemisch von Silicium und Germanium bestehen. Unter einer "reinen" Beschichtung ist dabei eine Beschichtung zu verstehen, die zu mindestens 90 Mol.-%, bevorzugt mindestens 95 Mol.-%, besonders bevorzugt mindestens 97 Gew.-% bezogen auf die Summe aller anwesenden (Halb)Metalle aus Silicium und/oder Germanium besteht. Ebenfalls kann es sich bei den nach dem erfindungsgemäßen Verfahren hergestellten strukturierten Beschichtungen um Beschichtungen handeln, die neben Silicium und/oder Germanium auch andere Elemente enthalten. Bevorzugt handelt es sich bei den mit dem erfindungsgemäßen Verfahren herstellbaren strukturierten Beschichtungen um solche aus reinem Silicium, reinem Germanium oder einem reinen Gemisch von Silicium und Germanium.

Unter einer "strukturierten" Silicium- und/oder Germanium-haltigen Beschichtung ist vorliegend eine Beschichtung zu verstehen, die das Substrat nicht vollständig oder im Wesentlichen vollständig bedeckt, sondern die das Substrat partiell unter Erzeugung einer Strukturierung bedeckt. Entsprechende Strukturierungen können insbesondere in der Halbleitertechnik die Lösung technischer Aufgaben übernehmen. Typische Beispiele für strukturierte Schichten sind Leiterbahnen (z.B. für Kontaktierungen), Fingerstrukturen oder punktförmige Strukturen (z.B. für Emitter- und Basisbereiche bei Back-Contact-Solarzellen) und selektive Emitter-Strukturen bei Solarzellen. Alternativ zu "strukturierte Silicium- und/oder Germanium-haltige Beschichtung" wird vorliegend auch synonym der Begriff "Silicium- und/oder Germanium-haltige Schichtstruktur" eingesetzt.

Unter Beschichtungszusammensetzungen im Sinne der vorliegenden Erfindung sind bei SATP-Bedingungen (25 °C, 1,013 bar) flüssige Zusammensetzungen zu verstehen, die entweder mindestens einen bei SATP-Bedingungen flüssigen Silicium- und/oder Germanium-haltigen Precursor enthalten oder daraus bestehen oder mindestens ein Lösemittel und mindestens einen bei SATP-Bedingungen flüssigen oder festen Silicium- und/oder Germanium-haltigen Precursor enthalten oder daraus bestehen. Besonders gute Ergebnisse können mit Beschichtungszusammensetzungen umfassend mindestens ein Lösemittel und mindestens einen bei SATP-Bedingungen flüssigen oder festen Silicium- und/oder Germanium-haltigen Precursor erzielt werden, da sich diese besonders gut verdrucken lassen. Unter einem Precursor ist dabei eine flüssige oder feste Silicium- und/oder Germanium-haltige Verbindung oder eine Sorte Silicium- und/oder Germanium-haltiger Partikel zu verstehen, aus dem über mindestens eine Konvertierungsart ausgewählt aus thermische Konvertierung, Konvertierung mit elektromagnetischer Strahlung, Elektronenstrahl- und Ionenbeschuss eine Silicium- und/oder Germanium-haltige Beschichtung hergestellt werden kann. Handelt es sich bei dem eingesetzten Precursor um ein Silicium- und/oder Germanium-haltiges Partikel, handelt es sich hierbei bevorzugt um ein Silicium- und/oder Germanium-haltiges Nanopartikel. Unter Nanopartikeln sind dabei kleine Feststoffteilchen zu verstehen, deren drei Dimensionen im Wesentlichen zwischen 1 und 100 nm liegen. Wie entsprechende Silicium- und/oder Germanium-haltigen Nanopartikel hergestellt werden können, ist dem Fachmann bekannt.

Bevorzugt handelt es sich bei den erfindungsgemäß eingesetzten Silicium- und/oder Germanium-haltigen Precursoren um Silicium- und/oder Germanium-haltige Verbindungen.

Bevorzugte Silicium- und/oder Germanium-haltige Precursoren sind bei SATP-Bedingungen (insbesondere flüssige oder feste) Silicium- oder Germanium-haltige Verbindungen der Formel MₙX_{c} mit M = Si und/oder Ge, X = H, F, Cl, Br, I, C₁-C₁₀-Alkyl-, C₁C₁₀-Alkenyl, C₅-C₂₀-Aryl, n ≥ 4 und 2n ≤ c ≤ 2n+2. Entsprechende Verbindungen gehören zum Stand der Technik.

Besonders gute Ergebnisse lassen sich erhalten, wenn eine Beschichtungszusammensetzung eingesetzt wird, die mindestens zwei Precursoren aufweist, von denen mindestens einer ein Hydridosilan der generischen Formel SiₙH₂ₙ₊₂ mit n = 3 bis 10 und mindestens einer ein Hydridosilan-Oligomer ist. Entsprechende Formulierungen eignen sich insbesondere zur Herstellung hochqualitativer, dünner und feiner Schichten aus der flüssigen Phase, benetzen im Beschichtungsprozess gängige Substrate gut und weisen scharfe Kanten nach der Strukturierung auf.

Bei dieser Beschichtungszusammensetzung handelt es sich um eine Zusammensetzung, die mindestens ein Hydridosilan und mindestens ein Hydridosilan-Oligomer umfasst oder aus einem Gemisch der beiden besteht. Bevorzugt ist die Formulierung flüssig, da sie so besonders gut handhabbar ist. Entsprechende Beschichtungszusammensetzungen haben den Vorteil, sich besonders für die Abscheidung hochwertiger Silicium-haltiger Schichten zu eignen.

Hydridosilane der Formel SiₙH₂ₙ₊₂ mit n = 3 bis 10 sind nicht-cyclische Hydridosilane. Die Isomere dieser Verbindungen können linear oder verzweigt sein. Bevorzugte nicht-cyclische Hydridosilane sind Trisilan, iso-Tetrasilan, n-Pentasilan, 2-Silyl-Tetrasilan und Neopentasilan sowie Octasilan (d.h. n-Octasilan, 2-Silyl-Heptasilan, 3-Silyl-Heptasilan, 4-Silyl-Heptasilan, 2,2-Disilyl-Hexasilan, 2,3-Disilyl-Hexasilan, 2,4-Disilyl-Hexasilan, 2,5-Disilyl-Hexasilan, 3,4-Disilyl-Hexasilan, 2,2,3- Trisilal-Pentasilan, 2,3,4-Trisilyl-Pentasilan, 2,3,3-Trisilyl-Pentasilan, 2,2,4-Trisilal-Pentasilan, 2,2,3,3-Tetrasilyl-Tetrasilan, 3-Disilyl-Hexasilan, 2-Silyl-3-disilyl-Pentasilan und 3-Silyl-3-disilyl-Pentasilan) und Nonasilan (d.h. n-Nonasilan, 2-Silyl-Oktasilan, 3-Silyl-Oktasilan, 4-Silyl-Oktasilan, 2,2-Disilyl-Heptasilan, 2,3-Disilyl-Heptasilan, 2,4-Disilyl-Heptasilan, 2,5-Disilyl-Heptasilan, 2,6-Disilyl-Heptasilan, 3,3-Disilyl-Heptasilan, 3,4-Disilyl-Heptasilan, 3,5-Disilyl-Heptasilan, 4,4-Disilyl-Heptasilan, 3-Disilyl-Heptasilan, 4-Disilyl-Heptasilan, 2,2,3-Trisilyl-Hexasilan, 2,2,4-Trisilyl-Hexasilan, 2,2,5-Trisilyl-Hexasilan, 2,3,3-Trisilyl-Hexasilan, 2,3,4-Trisilyl-Hexasilan, 2,3,5-Trisilyl-Hexasilan, 3,3,4-Trisilyl-Hexasilan, 3,3,5-Trisilyl-Hexasilan, 3-Disilyl-2-Silyl-Hexasilan, 4-Disilyl-2-Silyl-Hexasilan, 3-Disilyl-3-Silyl-Hexasilan, 4-Disilyl-3-Silyl-Hexasilan, 2,2,3,3-Tetrasilyl-Pentasilan, 2,2,3,4-Tetrasilyl-Pentasilan, 2,2,4,4-Tetrasilyl-Pentasilan, 2,3,3,4-Tetrasilyl-Pentasilan, 3-Disilyl-2,2-Disilyl-Pentasilan, 3-Disilyl-2,3-Disilyl-Pentasilan, 3-Disilyl-2,4-Disilyl-Pentasilan und 3,3-Disilyl-Pentasilan), deren Formulierungen zu besonders guten Ergebnissen führen.

Ebenfalls bevorzugt handelt es sich bei dem Hydridosilan der genannten generischen Formel um ein verzweigtes Hydridosilan, das zu stabileren Lösungen und besseren Schichten führt als ein lineares Hydridosilan.

Ganz besonders bevorzugt ist das Hydridosilan iso-Tetrasilan, 2-Silyl-Tetrasilan, Neopentasilan oder ein Gemisch von Nonasilan-Isomeren, das hergestellt werden kann über thermische Behandlung von Neopentasilan oder nach einer durch Holthausen et al. beschrieben Vorschrift (Posterpräsentation: A. Nadj, 6th European Silicon Days, 2012). Mit entsprechenden Formulierungen können die besten Ergebnisse erzielt werden. Noch weiter bevorzugt ist das Hydridosilan iso-Tetrasilan, 2-Silyl-Tetrasilan oder Neopentasilan.

Bei dem Hydridosilan-Oligomer handelt es sich um das Oligomerisat einer Hydridosilan-Verbindung und bevorzugt um das Oligomerisat eines Hydridosilans. Besonders gut eignet sich die erfindungsgemäße Formulierung für die Herstellung dünner Schichten, wenn das Hydridosilan-Oligomer ein gewichtsmittleres Molekulargewicht von 200 bis 10.000 g/ml aufweist. Verfahren zur ihrer Herstellung sind dem Fachmann bekannt. Entsprechende Molekulargewichte können über Gelpermeations-Chromatographie unter Verwendung einer linearen Polystyrolsäule mit Cyclooktan als Eluent gegen Polybutadien als Referenz bestimmt werden.

Das Hydridosilan-Oligomer wird bevorzugt durch Oligomerisation nicht-cyclischer Hydridosilane erhalten. Anders als Hydridosilan-Oligomere aus cyclischen Hydridosilanen weisen diese Oligomere aufgrund des unterschiedlich ablaufenden, dissoziativen Polymerisationsmechanismus einen hohen Quervernetzungsanteil auf. Oligomere aus cylischen Hydridosilanen haben stattdessen aufgrund des ringöffnenden Reaktionsmechanismus, dem cyclische Hydridosilane unterworfen sind, wenn überhaupt, nur einen sehr geringen Quervernetzungsanteil. Entsprechende aus nicht-cyclischen Hydridosilanen hergestellte Oligomere benetzen anders als Oligomere aus cyclischen Hydridosilanen in Lösung die Substratoberfläche gut, können für die Herstellung dünner Schichten besonders gut eingesetzt werden und führen zu homogenen und glatten Oberflächen. Noch bessere Ergebnisse zeigen Oligomere aus nicht-cyclischen, verzweigten Hydridosilanen.

Ein besonders bevorzugtes Hydridosilan-Oligomer ist ein durch thermische Umsetzung einer Zusammensetzung umfassend mindestens ein nicht-cyclisches Hydridosilan mit maximal 20 Siliciumatomen in Abwesenheit eines Katalysators bei Temperaturen von < 235 °C erhältliches Oligomer. Entsprechende Hydridosilan-Oligomere und ihre Herstellung werden in WO 2011/104147 A1 beschrieben, worauf in Bezug auf die Verbindungen und ihre Herstellung Bezug genommen wird. Dieses Oligomer weist noch bessere Eigenschaften auf als die weiteren Hydridosilan-Oligomere aus nicht-cyclischen, verzweigten Hydridosilanen.

Das Hydridosilan-Oligomer kann neben Wasserstoff und Silicium noch andere Reste aufweisen. So können Vorteile der mit den Formulierungen hergestellten Schichten resultieren, wenn das Oligomer kohlenstoffhaltig ist. Entsprechende kohlenstoffhaltige Hydridosilan-Oligomere können durch Co-Oligomerisation von Hydridosilanen mit Kohlenwasserstoffen hergestellt werden. Bevorzugt handelt es sich jedoch bei dem Hydridosilan-Oligomer um eine ausschließlich Wasserstoff- und Silicium-aufweisende Verbindung, die also keine Halogen- oder Alkylreste aufweist.

Bevorzugt zur Herstellung dotierter Silicium-haltiger Beschichtungen sind weiterhin Hydridosilan-Oligomere, die dotiert sind. Bevorzugt sind die Hydridosilan-Oligomere bor- oder phosphordotiert und entsprechende Formulierungen eignen sich zur Herstellung p- bzw. n-dotierter Siliciumschichten. Entsprechende Hydridosilan-Oligomere können durch Zugabe der entsprechenden Dotierstoffe bereits bei ihrer Herstellung erzeugt werden. Alternativ können auch bereits hergestellte, nicht dotierte Hydridosilan-Oligomere mit Stoffen ausgewählt aus der Gruppe der p-Dotanden, bevorzugt der Hydroborierungsreagenzien (insbesondere B₂H₆, BH₃*THF, BEt₃, BMe₃) p-dotiert oder mit n-Dotanten (insbesondere PH₃, P₄) mittels eines energetischen Prozesses (z.B. UV-Bestrahlung oder thermische Behandlung) n-dotiert werden.

Der Anteil des bzw. der Hydridosilane beträgt bevorzugt 0,1 bis 99 Gew.-%, weiter bevorzugt 1 bis 50 Gew.-%, ganz besonders bevorzugt 1 bis 30 Gew.-% bezogen auf die Gesamtmasse der Beschichtungszusammensetzung.

Der Anteil des bzw. der Hydridosilan-Oligomere beträgt bevorzugt 0,1 bis 99 Gew.-%, weiter bevorzugt 1 bis 50 Gew.-%, ganz besonders bevorzugt 1 bis 20 Gew.-% bezogen auf die Gesamtmasse der Beschichtungszusammmensetzung.

Der Anteil des Hydridosilan-Oligomers an der Beschichtungszusammensetzung, beträgt weiterhin zur Erzielung besonders guter Ergebnisse bevorzugt 40 - 99,9 Gew.-%, besonders bevorzugt 60 - 99, ganz besonders bevorzugt 70 - 90 Gew.-% bezogen auf die Gesamtmasse an anwesendem Hydridosilan und Hydridosilan-Oligomer

Die bei dem erfindungsgemäßen Verfahren eingesetzte Beschichtungszusammensetzung muss kein Lösemittel enthalten. Bevorzugt weist sie jedoch mindestens ein Lösemittel auf. Enthält sie ein Lösemittel, beträgt dessen Anteil bevorzugt 0,1 bis 99 Gew.-%, weiter bevorzugt 25 bis 95 Gew.-%, ganz besonders bevorzugt 60 bis 95 Gew.-% bezogen auf die Gesamtmasse der Formulierung.

Ganz besonders bevorzugt ist eine Beschichtungszusammensetzung aufweisend 1 - 30 Gew.-% Hydridosilan, 1 - 20 Gew.-% Hydridosilan-Oligomer und 60 - 95 Gew.-% Lösemittel, bezogen auf die Gesamtmasse der Formulierung.

Für die Beschichtungszusammensetzungen bevorzugt einsetzbare Lösemittel sind die ausgewählt aus der Gruppe bestehend aus linearen, verzweigten oder cyclischen gesättigten, ungesättigten oder aromatischen Kohlenwasserstoffen mit 1 bis 12 Kohlenstoffatomen (ggf. partiell oder vollständig halogeniert), Alkoholen, Ethern, Carbonsäuren, Estern, Nitrilen, Aminen, Amiden, Sulfoxiden und Wasser. Besonders bevorzugt sind n-Pentan, n-Hexan, n-Heptan, n-Oktan, n-Dekan, Dodekan, Cyclohexan, Cyclooctan, Cyclodekan, Dicyclopentan, Benzol, Toluol, m-Xylol, p-Xylol, Mesitylen, Indan, Inden, Tetrahydronaphtalin, Decahydronaphtalin, Diethylether, Dipropylether, Ethylenglycoldimethylether, Ethylenglycoldiethylether, Ethylenglycol-methylethylether, Diethylenglycoldimethylether, Diethylenglycol-diethylether, Diethylenglycolmethylethylether, Tetrahydrofuran, p-Dioxan, Acetonitril, Dimethylformamid, Dimethylsulfoxid, Dichlormethan und Chloroform.

Die erfindungsgemäße Formulierung kann weiterhin neben dem mindestens einen Hydridosilan und dem mindestens einen Hydridosilan-Oligomer und dem oder den ggf. anwesenden Lösemitteln noch weitere Stoffe, insbesondere Dotierstoffe (bevorzugt B₂H₆, BH₃*THF, BEt₃, BMe₃, PH₃, P₄), Nanopartikel oder Additive zur Einstellung der rheologischen Eigenschaften aufweisen. Entsprechende Stoffe sind dem Fachmann bekannt.

Für das erfindungsgemäße Verfahren können eine Vielzahl von Substraten eingesetzt werden. Bevorzugt sind Substrate bestehend aus Glas, Quarzglas, Graphit, Metall, Silicium oder bestehend aus einer auf einem hitzeverträglichen Träger befindlichen Silicium-, Indiumzinnoxid-, ZnO:F-, ZnO:Al- oder SnO₂:F-Schicht. Bevorzugte Metalle sind Aluminium, Edelstahl, Cr-Stahl, Titan, Chrom bzw. Molybdän. Ferner können bei Wahl geeigneter Konvertierungsbedingungen auch Kunststofffolien (z. B. aus PEEK, PEN, PET oder Polyimiden) eingesetzt werden.

Das Aufbringen der Formulierung erfolgt bevorzugt über ein Flüssigphasenverfahren ausgewählt aus Druckverfahren (insbesondere Flexo/Gravur-Druck, Nano- bzw. Mikroimprint, Inkjet-Druck, Offset-Druck, reverse Offset-Druck, digitalem Offset-Druck und Siebdruck), Sprühverfahren, aerosol assisted chemical vapour deposition, direct liquid injection chemical vapour deposition, Rotationsbeschichtungsverfahren ("Spin-coating"), Tauchverfahren ("Dipcoating") und Verfahren ausgewählt aus Meniscus Coating, Slit Coating, Slot-Die Coating, und Curtain Coating. Von den zuvor genannten Verfahren sind dabei aerosol assisted chemical vapour deposition und direct liquid injection chemical vapour deposition den Gasphasenverfahren zuzuordnen.

Das Aufbringen der mindestens einen Beschichtungszusammensetzung kann prinzipiell flächig (d.h. unstrukturiert) oder strukturiert erfolgen. Besonders feine Strukturen können mit dem erfindungsgemäßen Verfahren erzielt werden, wenn auch bereits das Aufbringen der Beschichtungszusammensetzung auf das Substrat strukturiert erfolgt. Ein entsprechendes strukturiertes Aufbringen kann z.B. durch den Einsatz von Druckprozessen realisiert werden. Möglich ist auch eine Strukturierung über Oberflächenvorbehandlung des Substrates, insbesondere über eine Modifizierung der Oberflächenspannung zwischen Substrat und der precursorhaltigen Beschichtungszusammensetzung durch eine lokale Plasma- bzw. CoronaBehandlung und somit einer lokalen Entfernung von chemischen Bindungen an der Substratoberfläche oder einer lokalen Aktivierung der Oberfläche (z.B. Si-H Terminierung), durch chemische Ätzungen oder Aufbringen chemischer Verbindungen (insbesondere durch self-assembled monolayers). Damit wird eine Strukturierung insbesondere dadurch erreicht, dass die precursorhaltige Beschichtungszusammensetzung nur an den vordefinierten Bereichen mit günstiger Oberflächenspannung haftet und/oder dass die getrocknete oder konvertierte Schicht nur an vordefinierten Bereichen mit günstiger Oberflächenspannung haftet. Bevorzugt lässt sich das erfindungsgemäße Verfahren jedoch mit Druckverfahren durchführen.

Besonders bevorzugt wird das erfindungsgemäße Verfahren so durchgeführt, dass mindestens zwei unterschiedliche Beschichtungszusammensetzungen gleichzeitig oder nacheinander sowie mit oder ohne Überlapp auf unterschiedliche Bereiche eines Substrates strukturiert aufgebracht, die resultierenden Beschichtungen partiell aktiviert und nicht aktivierte Beschichtungsbereiche auf dem Substrat oxidiert werden. Hiermit können besonders feine Strukturen mit unterschiedlichen Eigenschaften hergestellt werden. Bevorzugt handelt es sich weiterhin bei mindestens einer der Beschichtungszusammensetzungen um eine für die Herstellung intrinsischer Silicium-Schichten geeignete Zusammensetzung (d.h. enthaltend mindestens einen Silicium-Precursor und keine Dotierstoffe) und bei mindestens einer weiteren der Beschichtungszusammensetzungen um eine für die Herstellung (p- oder n-)dotierter Silicium-Schichten geeignete Zusammensetzung (d.h. enthaltend Siliciumprecursoren und mindestens einen p- oder n-Dotierstoff, bevorzugt mindestens ein entsprechende Bor- oder Phosphor-haltige Verbindung). Mit einem entsprechenden Verfahren können besonders gute und einfach strukturierte Schichten für elektronische Bauteile mit speziellen Anforderungen hergestellt werden. Ein weiterer Vorteil dieses Verfahrens ist, dass für ein entsprechendes Verfahren nur ein Aktivierungs- und ein Oxidationsschritt erforderlich sind. Bevorzugt wird das Flüssigphasenverfahren somit derart durchgeführt, dass in der Reihenfolge der Schritte 1 bis 3
1. mindestens zwei unterschiedliche Beschichtungszusammensetzungen auf ein Substrat aufgebracht,
2. die nach dem Aufbringen aller Beschichtungszusammensetzungen resultierende Beschichtung auf dem beschichteten Substrat partiell aktiviert und
3. nicht aktivierte Beschichtung auf dem beschichteten Substrat oxidiert wird.

Bevorzugt handelt es sich weiterhin bei mindestens einer der Beschichtungszusammensetzungen um eine für die Herstellung intrinsischer Silicium-Schichten geeignete Zusammensetzung (d.h. enthaltend mindestens einen Silicium-Precursor und keine Dotierstoffe) und bei mindestens einer weiteren der Beschichtungszusammensetzungen um eine für die Herstellung (p- oder n-)dotierter Silicium-Schichten geeignete Zusammensetzung (d.h. enthaltend Siliciumprecursoren und mindestens einen p- oder n-Dotierstoff, bevorzugt mindestens ein entsprechende Bor- oder Phosphor-haltige Verbindung). Die beiden Beschichtungszusammensetzungen können auch hier mit oder ohne Überlapp aufgebracht werden.

Nach dem Aufbringen der Formulierung kann bevorzugt eine Vorvernetzung über eine UV-Bestrahlung des flüssigen Filmes auf dem Substrat durchgeführt werden, nach der der noch flüssige Film quervernetzte Precursoranteile aufweist.

Nach Aufbringen und ggf. Vorvernetzen der Formulierung kann das beschichtete Substrat weiterhin bevorzugt vor der Aktivierung bzw. Konvertierung getrocknet werden, um ggf. anwesendes Lösemittel zu entfernen. Entsprechende Maßnahmen und Bedingungen hierfür sind dem Fachmann bekannt. Um ausschließlich leicht flüchtige Formulierungsbestandteile zu entfernen, sollte im Falle einer thermischen Trocknung die Heiztemperatur weniger als 200 °C betragen.

Im Anschluss an das Aufbringen auf das Substrat und eine ggf. anschließende Vorvernetzung und/oder Trocknung wird die auf dem Substrat befindliche Beschichtungszusammensetzung partiell aktiviert. Im Fall eines flächigen, d.h. unstrukturierten Aufbringens der Beschichtungszusammensetzung erfolgt somit erstmalig eine Strukturierung der resultierenden Beschichtung. In dem Fall, dass die bereits das Aufbringen der Beschichtungszusammensetzung strukturiert erfolgte, kann mit der partiellen Aktivierung der strukturierten Beschichtung eine besonders fein strukturierte Silicium- und/oder Germanium-haltige Beschichtung erzeugt werden.

Die partielle Aktivierung kann dabei zum Beispiel durch Verwendung einer Maske oder durch Verwendung von Kontaktstempeln erfolgen.

Die Aktivierung des erfindungsgemäßen Verfahrens kann prinzipiell verschieden erfolgen. Bevorzugt ist wird die Aktivierung bzw. Konvertierung thermisch, unter Verwendung elektromagnetischer Strahlung und/oder durch Elektronen- oder Ionenbeschuss durchgeführt.

Thermische Aktivierung wird bevorzugt bei Temperaturen von 200 - 1000 °C, vorzugsweise 250 - 750 °C, insbesondere bevorzugt 300 - 700 °C durchgeführt. Thermische Aktivierungszeiten betragen bevorzugt zwischen 0,1 ms und 360 min. Die Aktivierungszeit beträgt weiter bevorzugt zwischen 0,1 ms und 10 min, besonders bevorzugt zwischen 1 s und 120 s.

Entsprechende schnelle energetische Prozessführungen können zum Beispiel durch den Einsatz eines IR-Strahlers, einer Heizplatte, eines Heizstempels, einem Ofen, einer Blitzlampe, eines Plasmas (insbesondere eines Wasserstoffplasmas) oder einer Corona mit geeigneter Gaszusammensetzung, einer RTP-Anlage, einer Mikrowellenanlage oder einer Elektronenstrahlbehandlung (wenn erforderlich, im jeweils vorgeheizten bzw. warmgelaufenen Zustand) erfolgen.

Alternativ bzw. ergänzend kann eine Aktivierung durch Bestrahlen mit elektromagnetischer Strahlung, insbesondere mit UV-Licht, erfolgen. Die Aktivierungszeit kann dabei bevorzugt zwischen 1 s und 360 min betragen. Die Strukturierung bzw. partielle Aktivierung kann in diesem Falle z.B. durch Verwendung punkt- oder linienförmiger Strahlungsquellen oder durch die Verwendung von Masken realisiert werden. Besonders bevorzugt wird die Aktivierung durch Bestrahlung mit Laserstrahlung durchgeführt. Die Verwendung punkt- oder linienförmiger Strahlungsquellen, insbesondere von Lasern, ist vorteilhaft, da hiermit besonders feine Strukturen erzielt werden können. Zudem kann bei Verwendung monochromatischer Strahlung über ein gezieltes Einstellen der für die Aktivierung notwendigen Wellenlänge die parasitäre Absorption reduziert und damit das unerwünschte Erwärmen von Substrat und/oder Umgebung verhindert werden. Die Verwendung elektromagnetischer Strahlung für die Aktivierung ist aufgrund dessen somit bevorzugt.

Ebenfalls möglich ist eine Aktivierung unter Ionenbeschuss. Die Ionen können dabei auf verschiedene Weisen erzeugt werden. Häufig kommen Stoßionisation, insbesondere Elektronenstoßionisation (EI) oder chemische Ionisation (CI), Photoionisation (PI), Feldionisation (FI), Fast Atom Bombardment (FAB), Matrix-unterstützte Laser-Desorption/Ionisation (MALDI) und Elektrospray-Ionisation (ESI) zum Einsatz. Eine Strukturierung kann im Falle des Ionenbeschusses ebenfalls über Masken erzielt werden.

Die partielle Aktivierung führt somit zu Bereichen auf dem Substrat, bei denen die darauf befindliche Beschichtungszusammensetzung konvertiert wurde, und zu Bereichen, in denen die darauf befindliche Beschichtungszusammensetzung nicht konvertiert wurde.

Unter einer Aktivierung kann vorliegend eine Umwandlung der abgeschiedenen Precursoren des entstandenen Beschichtungsfilms in amorphe oder kristalline Halbleiterschichten verstanden werden. Bevorzugt wird die Aktivierung im Falle der Verwendung ausschließlich Silicium-haltiger Precursoren so durchgeführt, dass nach der Konvertierung strukturierte amorphe oder kristalline, insbesondere poly- oder monokristalline, Siliciumschichten resultieren. Mittel und Wege hierzu sind dem Fachmann bekannt.

Wurde vor der Konvertierung nicht getrocknet, können die nicht konvertierten Bereiche auch nach der partiellen Konvertierung getrocknet werden. Die Trocknung erfolgt auch hier bei Temperaturen unterhalb von 200 °C, bevorzugt im Bereich von 100 bis 200 °C. Über die Trocknung können auch in den Bereichen mit nicht konvertierter Beschichtung definierte Zustände eingestellt werden, mit denen die optischen und elektrischen Eigenschaften der Beschichtung nach dem nun anschließenden Oxidationsschritt mit gesteuert werden können.

Nach der partiellen Konvertierung wird nicht konvertierte Beschichtung auf dem Substrat oxidiert. Es entstehen somit in den Bereichen mit nicht konvertierter Beschichtung Siliciumoxid- und/oder Germaniumoxid-haltige Schichtstrukturen. Die bereits durch die vorherige Konversion erhaltenen konvertierten Silicum- und/oder Germanium-haltigen Bereiche werden dabei nicht oxidiert, so dass mit dem erfindungsgemäßen Verfahren Silicium- und/oder Germanium-haltige Schichtstrukturen erhalten werden können, die direkt an Siliciumoxid- und/oder Germaniumoxid-haltige Schichtstrukturen angrenzen. Beide Schichtstrukturen unterscheiden sich in ihren elektronischen Eigenschaften, so dass gegenüber dem Stand der Technik über einen einfacheren Weg strukturierte Schichten hergestellt werden können. So können mit dem erfindungsgemäßen Verfahren bei Wahl geeigneter Beschichtungszusammensetzungen z.B. halbleitenden Silicium- und/oder Germanium-Schichten hergestellt werden, die benachbart zu Siliciumoxid- oder Germaniumoxid-Schichten sind, die als Passivierungs- oder Isolationsschichten dienen können. Ein großer Vorteil der Oxidation der nicht konvertierten Bereiche (gegenüber ihrer Entfernung) ist, dass im Falle der Fehlfunktion von z.B. Druckdüsen Kurzschlüsse vermieden werden können. Weiterhin stellen Siliciumoxid- und/oder Germaniumoxid-haltige Schichtstrukturen bessere Passivierungsschichten dar als andere im Stand der Technik bekannte Alternativen. Weiterhin entfällt ein separater Applikationsschritt für diese Passivierungsschichten, da der Precursor für selbige bereits mit der Beschichtungszusammensetzung für die Herstellung der Silicium- und/oder Germanium-haltigen Schicht auf das Substrat aufgebracht wurde.

Dem Fachmann ist bekannt, wie er die Oxidationsbedingungen wählen muss, damit nicht konvertierte Beschichtungsbereiche oxidiert werden können, ohne dass bereits konvertierte Bereiche ebenfalls oxidiert werden.

Bevorzugt erfolgt die Oxidation in einer Sauerstoff-haltigen Atmosphäre bei einer Temperatur ≤ 300 °C, weiter bevorzugt bei einer Temperatur ≤ 150 °C, besonders bevorzugt bei einer Temperatur ≤ 100 °C. Ganz besonders bevorzugt erfolgt die Oxidation in einer Sauerstoff-haltigen Atmosphäre bei Raumtemperatur. Die Sauerstoff-haltige Atmosphäre hat bevorzugt eine Sauerstoff-Konzentration von 1 - 100 Mol-% und kann z.B. als weitere gasförmige Bestandteile Stickstoff oder Argon enthalten.

Besonders bevorzugt ist weiterhin die Oxidation mit Oxidationsmitteln ausgewählt aus der Gruppe bestehend aus Ozon, Kohlendioxid, Wasserstoffperoxid (H₂O₂), Wasserdampf (H₂O), einem ein- oder mehrwertigem Alkohol, einem Keton, einer Carbonsäure (insbesondere Trichloressigsäure), einem Kohlensäureester und Gemischen umfassend Trichloressigsäure und Sauerstoff sowie HCl und Sauerstoff. Mittel und Wege zur Oxidation mit diesen Oxidationsmitteln sind dem Fachmann bekannt. Besonders bevorzugt ist die Verwendung von Ozon, Kohlendioxid, Wasserstoffperoxid (H₂O₂), Wasserdampf (H₂O), einer Carbonsäure (insbesondere Trichloressigsäure), einem Kohlensäureester und einem Gemisch umfassend Trichloressigsäure und Sauerstoff.

Das beschriebene Verfahren zur Herstellung strukturierter Silicium- und/oder Germanium-haltiger Schichten kann weiterhin bezogen auf ein Substrat gleichzeitig oder zeitlich hintereinander mehrfach durchgeführt werden (Gleichzeitiges oder aufeinander folgendes Abscheiden, wobei die resultierenden Filme teilweise oder komplett übereinanderliegen oder sich auf verschiedenen Seiten des Substrates befinden. Die Aktivierung unterschiedlicher Beschichtungen kann somit gleichzeitig oder nacheinander erfolgen.). Ein solches Verfahren zur Herstellung von strukturierten Mehrschichtsystemen eignet sich bevorzugt zur Herstellung von Systemen aufgebaut aus intrinsischen (d. h. nicht dotierten) und dotierten Schichten, die z. B. essentiell für den Aufbau von Solarzellen sind.

Während der oder im Anschluss an die Konvertierung, insbesondere nach der Oxidation, kann weiterhin bevorzugt eine Anreicherung der siliciumhaltigen Schichten mit Wasserstoff durchgeführt werden. Dabei handelt es sich um eine sogenannte "Wasserstoffpassivierung", die Defekte im Material ausgleicht, und z. B. mit reaktivem Wasserstoff nach dem Hotwire Verfahren, mit einem wasserstoffhaltigen Plasma (remote oder direkt; im Vakuum oder unter Atmosphärendruck) oder mittels Coronabehandlung oder einer Elektronenstrahlbehandlung unter Zufuhr von Wasserstoff erfolgen kann. Weiterhin kann auch der bereits erwähnte Trocknungs- und/oder der Konvertierungsschritt in mit Wasserstoff angereicherter Atmosphäre durchgeführt werden, so dass das Material von vornherein wasserstoffreich ist.

Gegenstand der vorliegenden Erfindung sind weiterhin auch die nach dem erfindungsgemäßen Verfahren hergestellten strukturierten Silicium- und/oder Germanium-haltiger Beschichtungen.

Ebenfalls Gegenstand der vorliegenden Erfindung ist die Verwendung der strukturierten Beschichtungen für die Herstellung elektronischer oder optoelektronischer Bauteile. Insbesondere eignen sich die erfindungsgemäß herstellbaren Schichtstrukturen (insbesondere als Basis- und Emitter-Bereiche) für die Verwendung in Back-Contact-Solarzellen.

Die nachfolgenden Beispiele erläutern den Gegenstand der vorliegenden Erfindung, ohne selbst beschränkend zu wirken.

### Beispiele:

### Beispiel 1

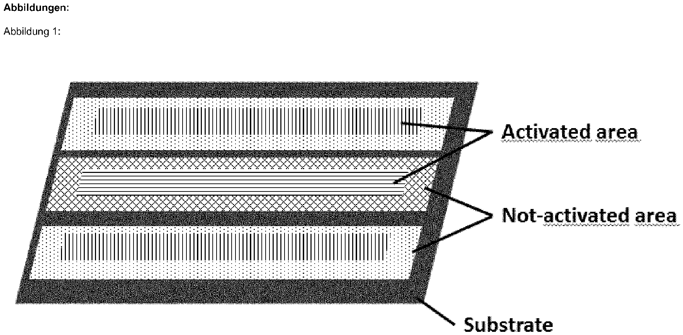

Abbildung 1 zeigt ein Substrat, auf dem lokal 2 unterschiedlicheTinten (gepunkteter und karierter Bereich) ohne Überlapp abgeschieden wurden. Diese Tinten wurden lokal in amorphes Silicium von Typ 1 (Querstreifen) und von Typ 2 ("Hochstreifen") umgewandelt. Die Umwandlung bzw. Konvertierung erfolgte linienförmig. Der konvertierte Bereich wird als "aktiviert" gekennzeichnet. Der nicht konvertierte Bereich ist als "nicht-aktiviert" gekennzeichnet. In diesem Bereich liegt ein Siliciumoxid vor.

### Beispiel 2

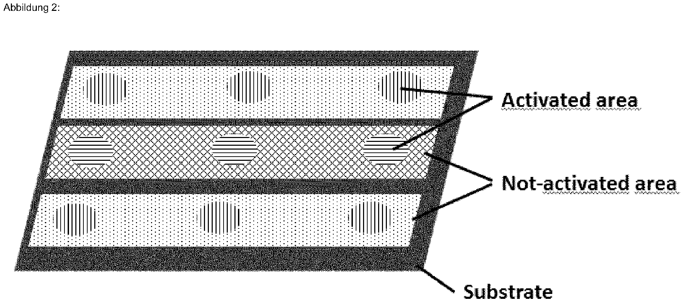

Abbildung 2 zeigt ein Substrat, auf dem lokal 2 unterschiedliche Tinten (gepunkteter und karierter Bereich) ohne Überlapp abgeschieden wurden. Diese Tinten wurden lokal in amorphes Silicium von Typ 1 (Querstreifen) und von Typ 2 ("Hochstreifen") umgewandelt. Die Umwandlung bzw. Konvertierung erfolgte punktförmig. Der konvertierte Bereich wird als "aktiviert" gekennzeichnet, der nicht konvertierte Bereich wird als "nicht-aktiviert" gekennzeichnet. In diesem Bereich liegt ein Siliciumoxid vor.

### Beispiel 3

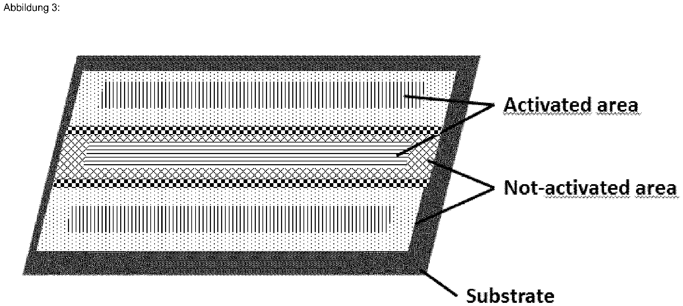

Abbildung 3 zeigt ein Substrat, auf dem lokal 2 verschiedene Tinten (gepunkteter bzw. karierter Bereich) mit Überlapp (schachfeldartige Bereiche) abgeschieden wurden. Diese Tinten wurden lokal in amorphes Silicium von Typ 1 (Querstreifen) und von Typ 2 ("Hochstreifen") umgewandelt. Die Umwandlung bzw. Konvertierung erfolgte linienförmig. Der konvertierte Bereich wird als "aktiviert" gekennzeichnet, der nicht konvertierte Bereich wird als "nicht-aktiviert" gekennzeichnet. In diesem Bereich liegt ein Siliciumoxid vor. Im vorliegenden Beispiel liegt in dem überlappenden Bereich ebenfalls ein Siliciumoxid vor.

## Patentansprüche

1. Flüssigphasenverfahren zur Herstellung strukturierter Silicium- und/oder Germanium-haltiger Beschichtungen,
**dadurch gekennzeichnet, dass**
- mindestens eine Beschichtungszusammensetzung auf ein Substrat aufgebracht,
- die resultierende Beschichtung auf dem beschichteten Substrat partiell aktiviert
- und nicht aktivierte Beschichtung auf dem Substrat oxidiert wird.

2. Verfahren nach Anspruch 1, **dadurch gekennzeichnet, dass** die
Beschichtungszusammensetzung mindestens ein Lösemittel und mindestens einen bei SATP-Bedingungen flüssigen oder festen Silicium- und/oder Germanium-haltigen Precursor umfasst.

3. Verfahren nach Anspruch 1 oder 2, **dadurch gekennzeichnet, dass** der Precursor die generische Formel MₙX_{c} mit M = Si und/oder Ge, X = H, F, Cl, Br, I, C₁-C₁₀-Alkyl-, C₁C₁₀-Alkenyl, C₅-C₂₀-Aryl, n ≥ 4 und 2n ≤ c ≤ 2n+2 hat.

4. Verfahren nach Anspruch 2, **dadurch gekennzeichnet, dass** der Precursor ein Silicium- und/oder Germanium-haltiges Nanopartikel ist.

5. Verfahren nach Anspruch 1 oder 2, **dadurch gekennzeichnet, dass** die Beschichtungszusammensetzung mindestens zwei Precursoren aufweist, von denen mindestens einer ein Hydridosilan-Oligomer und mindestens einer ein Hydridosilan der generischen Formel SiₙH₂ₙ₊₂ mit n = 3 bis 10 ist.

6. Verfahren nach Anspruch 5, **dadurch gekennzeichnet, dass** das Hydridosilan der Formel SiₙH₂ₙ₊₂ verzweigt ist.

7. Verfahren nach Anspruch 6, **dadurch gekennzeichnet, dass** das Hydridosilan iso-Tetrasilan, 2-Silyl-Tetrasilan, Neopentasilan oder ein Gemisch von Nonasilan-Isomeren ist.

8. Verfahren nach einem der Ansprüche 5 bis 7, **dadurch gekennzeichnet, dass** das Hydridosilan-Oligomer ein gewichtsmittleres Molekulargewicht von 200 bis 10.000 g/mol aufweist.

9. Verfahren nach einem der Ansprüche 5 bis 8, **dadurch gekennzeichnet, dass** das Hydridosilan-Oligomer durch Oligomerisation nicht-cyclischer Hydridosilane erhalten wurde.

10. Verfahren nach einem der Ansprüche 5 bis 9, **dadurch gekennzeichnet, dass** das Hydridosilan-Oligomer durch thermische Umsetzung einer Zusammensetzung umfassend mindestens ein nicht-cyclisches Hydridosilan mit maximal 20 Siliciumatomen in Abwesenheit eines Katalysators bei Temperaturen von kleiner 235 °C erhältlich ist.

11. Verfahren nach einem der vorhergehenden Ansprüche, **dadurch gekennzeichnet, dass** die Beschichtungszusammensetzung strukturiert auf das Substrat aufgebracht wird.

12. Verfahren nach Anspruch 11, **dadurch gekennzeichnet, dass** mindestens zwei unterschiedliche Beschichtungszusammensetzungen gleichzeitig oder nacheinander sowie mit oder ohne Überlapp auf unterschiedliche Bereiche eines Substrates strukturiert aufgebracht werden.

13. Verfahren nach einem der vorhergehenden Ansprüche, **dadurch gekennzeichnet, dass** die Oxidation in einer Sauerstoff-haltigen Atmosphäre bei einer Temperatur ≤ 300 °C erfolgt.

14. Verfahren nach einem der vorhergehenden Ansprüche, **dadurch gekennzeichnet, dass** die Oxidation mit einem Oxidationsmittel ausgewählt aus der Gruppe bestehend aus Ozon, Kohlendioxid, Wasserstoffperoxid (H₂O₂), Wasserdampf (H₂O), einem ein- oder mehrwertigem Alkohol, einem Keton, einer Carbonsäure, einem Kohlensäureester und Gemischen umfassend Trichloressigsäure und Sauerstoff sowie HCl und Sauerstoff durchgeführt wird.

## Claims

1. Liquid-phase process for producing structured silicon- and/or germanium-containing coatings, **characterized in that**
- at least one coating composition is applied to a substrate,
- the resulting coating on the coated substrate is partially activated
- and non-activated coating on the substrate is oxidized.

2. Process according to Claim 1, **characterized in that** the coating composition comprises at least one solvent and at least one silicon- and/or germanium-containing precursor which is solid or liquid under SATP conditions.

3. Process according to Claim 1 or 2, **characterized in that** the precursor has the generic formula MₙX_{c} with M = Si and/or Ge, X = H, F, Cl, Br, I, C₁-C₁₀ alkyl, C₁-C₁₀ alkenyl, C₅-C₂₀ aryl, n ≥ 4 and 2n ≤ c ≤ 2n+2.

4. Process according to Claim 2, **characterized in that** the precursor is a silicon- and/or germanium-containing nanoparticle.

5. Process according to Claim 1 or 2, **characterized in that** the coating composition has at least two precursors, of which at least one is a hydridosilane oligomer and at least one is a hydridosilane of the generic formula SiₙH₂ₙ₊₂ with n = 3 to 10.

6. Process according to Claim 5, **characterized in that** the hydridosilane of the formula SiₙH₂ₙ₊₂ is branched.

7. Process according to Claim 6, **characterized in that** the hydridosilane is isotetrasilane, 2-silyltetrasilane, neopentasilane or a mixture of nonasilane isomers.

8. Process according to any of Claims 5 to 7, **characterized in that** the hydridosilane oligomer has a weight-average molecular weight of 200 to 10.000 g/mol.

9. Process according to any of Claims 5 to 8, **characterized in that** the hydridosilane oligomer has been obtained by oligomerization of non-cyclic hydridosilanes.

10. Process according to any of Claims 5 to 9, **characterized in that** the hydridosilane oligomer is obtainable by thermal reaction of a composition comprising at least one non-cyclic hydridosilane having not more than 20 silicon atoms in the absence of a catalyst at temperatures of less than 235°C.

11. Process according to any of the preceding claims, **characterized in that** the coating composition is applied in structured form to the substrate.

12. Process according to Claim 11, **characterized in that** at least two different coating compositions are applied in structured form, simultaneously or successively and also with or without overlap, to different regions of a substrate.

13. Process according to any of the preceding claims, **characterized in that** the oxidation takes place in an oxygen-containing atmosphere at a temperature ≤ 300°C.

14. Process according to any of the preceding claims, **characterized in that** the oxidation is carried out with an oxidizing agent selected from the group consisting of ozone, carbon dioxide, hydrogen peroxide (H₂O₂), steam (H₂O), a mono- or polyhydric alcohol, a ketone, a carboxylic acid, a carbonic ester and mixtures comprising trichloroacetic acid and oxygen, and also HCl and oxygen.

## Revendications

1. Procédé en phase liquide pour la préparation de revêtements structurés, contenant du silicium et/ou du germanium, **caractérisé en ce que**
- au moins une composition de revêtement est appliquée sur un substrat,
- le revêtement résultant sur le substrat revêtu est partiellement activé
- et le revêtement non oxydé sur le substrat est oxydé.

2. Procédé selon la revendication 1, **caractérisé en ce que** la composition de revêtement comprend au moins un solvant et au moins un précurseur liquide ou solide aux conditions normales de température et de pression (CNTP), contenant du silicium et/ou du germanium.

3. Procédé selon la revendication 1 ou 2, **caractérisé en ce que** le précurseur présente la formule générique MₙX_{c}, dans laquelle M = Si et/ou Ge, X = H, F, Cl, Br, I, C₁-C₁₀₋alkyle, C₁-C₁₀₋alcényle, C₅-C₂₀-aryle, n ≥ 4 et 2n ≤ c ≤ 2n+2.

4. Procédé selon la revendication 2, **caractérisé en ce que** le précurseur est une nanoparticule contenant du silicium et/ou du germanium.

5. Procédé selon la revendication 1 ou 2, **caractérisé en ce que** la composition de revêtement présente au moins deux précurseurs, dont au moins l'un est un oligomère d'hydridosilane et au moins l'un est un hydridosilane de formule générique SiₙH₂ₙ₊₂ dans laquelle n = 3 à 10.

6. Procédé selon la revendication 5, **caractérisé en ce que** l'hydridosilane de formule SiₙH₂ₙ₊₂ est ramifié.

7. Procédé selon la revendication 6, **caractérisé en ce que** l'hydridosilane est l'iso-tétrasilane, le 2-silyl-tétrasilane, le néopentasilane ou un mélange d'isomères de nonasilane.

8. Procédé selon l'une quelconque des revendications 5 à 7, **caractérisé en ce que** l'oligomère d'hydridosilane présente un poids moléculaire pondéral moyen de 200 à 10.000 g/mole.

9. Procédé selon l'une quelconque des revendications 5 à 8, **caractérisé en ce que** l'oligomère d'hydridosilane a été obtenu par oligomérisation d'hydridosilanes non cycliques.

10. Procédé selon l'une quelconque des revendications 5 à 9, **caractérisé en ce que** l'oligomère d'hydridosilane peut être obtenu par transformation thermique d'une composition comprenant au moins un hydridosilane non cyclique présentant au maximum 20 atomes de silicium en l'absence d'un catalyseur à des températures inférieures à 235°C.

11. Procédé selon l'une quelconque des revendications précédentes, **caractérisé en ce que** la composition de revêtement est appliquée de manière structurée sur le substrat.

12. Procédé selon la revendication 11, **caractérisé en ce qu'**au moins deux compositions de revêtement différentes sont appliquées de manière structurée, simultanément ou successivement, ainsi qu'avec ou sans recouvrement, sur des zones différentes d'un substrat.

13. Procédé selon l'une quelconque des revendications précédentes, **caractérisé en ce que** l'oxydation a lieu dans une atmosphère contenant de l'oxygène à une température ≤ 300°C.

14. Procédé selon l'une quelconque des revendications précédentes, **caractérisé en ce que** l'oxydation est réalisée avec un oxydant choisi dans le groupe constitué par l'ozone, le dioxyde de carbone, le peroxyde d'hydrogène (H₂O₂), la vapeur d'eau (H₂O), un alcool monovalent ou polyvalent, une cétone, un acide carboxylique, un ester de l'acide carbonique et des mélanges comprenant de l'acide trichloroacétique et de l'oxygène ainsi que HCl et de l'oxygène.
